# FASCICULE DE BREVET EUROPEEN

(11) **EP 2 607 972 B1**
(45) Date de publication et mention de la délivrance du brevet: **27.04.2016**
(21) Numéro de dépôt: 11195404.6
(22) Date de dépôt: 22.12.2011
(51) Int. Cl.: G04G 17/00, G04B 3/04, G04B 37/10, H03K 17/96, H03K 17/975, H01H 13/06, G04C 3/00

(54) **Poussoir étanche pour montre**
Dichter Druckknopf für Armbanduhr
Watertight push button for watch

(43) Date de publication de la demande: 26.06.2013
(73) Titulaire: The Swatch Group Research and Development Ltd., 2074 Marin (CH)
(72) Inventeur: Ferri, Yvan, 1004 Lausanne (CH); Rota, Sergio, 2013 Colombier (CH); Martin, Jean-Claude, 2037 Montmollin (CH)
(74) Mandataire: Gilligmann, Benoît Philippe

(56) Documents cités:
- EP-A1- 0 838 737
- FR-A1- 2 327 623
- US-A- 2 262 777

## Description

La présente invention concerne un poussoir étanche pour montre bracelet, et plus particulièrement un poussoir étanche pour montre électronique comprenant un dispositif interrupteur de type capacitif ou résistif.

Les poussoirs mécaniques classiques comprennent en général une tête traversante par rapport à la carrure d'une boîte de montre, dont une extrémité inférieure vient s'appuyer sur un élément mobile ou plastiquement déformable, comme par exemple une lame, d'un dispositif d'actionnement. Lors de l'enfoncement du poussoir, l'extrémité de cette tête traversante entraîne le déplacement de l'élément mobile qui arrive en butée pour activer une fonction mécanique ou électronique. L'arrivée en butée permet du reste à l'utilisateur d'avoir une confirmation mécanique de l'activation effective de la fonction voulue par le poussoir. Toutefois, cette solution pose des problèmes d'étanchéité par rapport à l'intérieur du boîtier; en effet l'étanchéité n'est garantie qu'au repos mais jamais complètement lors d'une activation sous l'eau en raison du frottement exercé sur les joints, typiquement des O-rings, passé une profondeur relativement faible. Par ailleurs, la compression des joints augmente fortement le seuil de force à appliquer pour l'enfoncement du poussoir, ce qui en rend l'utilisation relativement malcommode.

On connaît par ailleurs des dispositifs d'actionnement de type capacitif, utilisés comme détecteurs de proximité par exemple pour des écrans tactiles ou par des appareils photographiques numériques. Ce type de dispositif peut certes permettre en théorie une isolation physique de l'intérieur d'un boîtier, car il ne nécessite pas d'élément traversant semblable à la solution usuelle pour les poussoirs de montre, mais il présente toutefois l'inconvénient de détecter automatiquement une variation de capacité électrique au contact de l'eau, ce qui le rend impropre à une utilisation en immersion où il ne serait plus possible de dissocier l'activation effective de la part de l'utilisateur de celle engendrée par le seul contact de l'eau. Par ailleurs, l'adaptation d'un tel dispositif aux dimensions d'une montre bracelet pose de gros problèmes en termes de seuils de détection car la capacité dépend entre autres d'un rapport entre la surface des armatures et leur espacement, qui devient délicat à gérer lorsque les surfaces de contact sont considérablement réduites, et surtout lorsque que l'espacement minimal entre les armatures est relativement grand, ce qui est le cas lorsque des éléments conducteurs de la capacité utilisée pour la détection sont agencés de part et d'autre d'une plaque hermétique isolante.

On connaît du reste également des dispositifs d'actionnement de type résistif, par exemple pour des claviers informatiques, selon lesquels l'enfoncement d'une touche en butée sur une surface conductrice permet de fermer un circuit électrique et d'activer une fonction électronique. On connaît également du document US2262777 un bouton poussoir formant un interrupteur électrique de type résistif, destiné à être intégré par exemple dans un joystick d'aviation. Une pression sur le poussoir permet de déformer une capsule sous laquelle est rivetée un élément conducteur mobile qui peut être amené en contact avec un élément conducteur fixe agencé dans le corps du poussoir. De tels dispositifs ne sont toutefois pas non plus adaptés à une utilisation sous l'eau en raison de leur absence d'étanchéité, ni ne peuvent être répliqués à une montre bracelet en raison de la forte consommation électrique requise pour la mise sous tension permanente du circuit de détection qui aurait un impact très négatif sur la durée de vie de la pile.

Dans le domaine de l'horlogerie, on connaît du document FR2327623 un poussoir couplé à un interrupteur électrique comprenant des éléments élastiques conducteurs en forme d'étoile, dont la déformation permet de fermer un circuit et qui exercent parallèlement une force de rappel pour revenir dans leur position de repos. L'étanchéité du poussoir n'est toutefois assurée que par des joints toriques, conformément à des poussoirs mécaniques classiques, avec les mêmes inconvénients de fiabilité en termes d'herméticité pour une activation lors d'une immersion, et de seuil de force minimal à appliquer en raison de la déformation du joint.

Il existe par conséquent un besoin pour un poussoir étanche pour montre bracelet exempt des limitations connues.

Ces buts sont atteints notamment grâce à un poussoir étanche selon la revendication principale, des modes de réalisation avantageux étant donnés dans les revendications dépendantes. Le poussoir étanche comprend une tête de poussoir mobile entre une position de repos et une position active, un premier élément conducteur fixe et un deuxième élément conducteur mobile. Il est caractérisé en ce qu'il comprend une capsule élastiquement déformable recouvrant hermétiquement le premier conducteur fixe, une surface supérieure de la capsule étant en contact physique avec une surface inférieure de la tête de poussoir, la capsule pouvant se trouver dans une position non déformée lorsque la tête de poussoir est dans sa position de repos et dans une position déformée lorsque la tête de poussoir est dans sa position active. Les premier et deuxième éléments conducteurs forment un dispositif interrupteur de type capacitif ou résistif, l'interrupteur étant à l'état ouvert lorsque la tête de poussoir est dans sa position de repos et à l'état fermé lorsque la tête poussoir est dans sa position de repos et à l'état fermé lorsque la tête de poussoir est dans sa position active.

Un avantage de la solution proposée est de permettre de garantir l'étanchéité par rapport à l'intérieur du boîtier de la montre, contrairement aux solutions usuelles de poussoirs totalement mécaniques, et également de minimiser la course requise pour la tête de poussoir, qui doit être relativement grande pour des montres bracelet usuelles afin de compenser toutes les erreurs de tolérance de placement des différentes pièces et garantir ainsi une activation effective par enclenchement mécanique lors de chaque enfoncement de la tête de poussoir.

Un autre avantage de la solution proposée est de garantir la fiabilité d'un enclenchement sous l'eau, par exemple pour une montre de plongée, uniquement suite à l'enfoncement d'un poussoir, sans être perturbé par la détection automatique de la présence de l'eau lors d'une immersion, contrairement à une solution classique de type capacitive qui ne serait plus en mesure de détecter l'enfoncement effectif du poussoir.

Un avantage additionnel de la solution proposée est de procurer, selon un mode de réalisation préférentiel, un « effet clic », c'est-à-dire un feedback mécanique à l'utilisateur de l'activation de la fonction souhaitée grâce à la déformation élastique d'une capsule utilisée pour étanchéifier le dispositif par rapport à l'extérieur de la carrure. Dès que la courbure de cette capsule s'inverse, l'utilisateur saura que la fonction aura été activée, et ce indépendamment du fait que celle-ci soit venue ou non en contact avec une surface de butée, notamment pour un mode de détection capacitif.

D'autres caractéristiques et avantages ressortiront plus clairement de la description détaillée de divers modes de réalisation préférentiels et des dessins annexés, dans lesquels:
- la figure 1 A montre une vue en coupe d'un poussoir selon un mode de réalisation préférentiel de l'invention, au repos;
- la figure 1 B montre un agrandissement de la figure 1 A au niveau du corps de l'assemblage du corps de poussoir, de la pièce étanche, de la pièce isolante et du premier élément conducteur fixe;
- la figure 1C montre une vue en perspective d'un poussoir selon le mode de réalisation préférentiel de la figure 1A, en mode assemblé dans la carrure et au repos;
- la figure 1 D montre une vue en coupe selon l'axe A-A du trou borgne agencé dans la carrure pour recevoir le mode de réalisation préférentiel du poussoir selon l'invention des figures 1 A et 1 B précédentes;
- la figure 2 montre une vue en coupe du poussoir selon le mode de réalisation préférentiel de l'invention des figures 1A et 1B précédentes, en position enfoncée;
- la figure 3 montre une vue en coupe d'un poussoir selon un mode de réalisation alternatif, en position enfoncée;

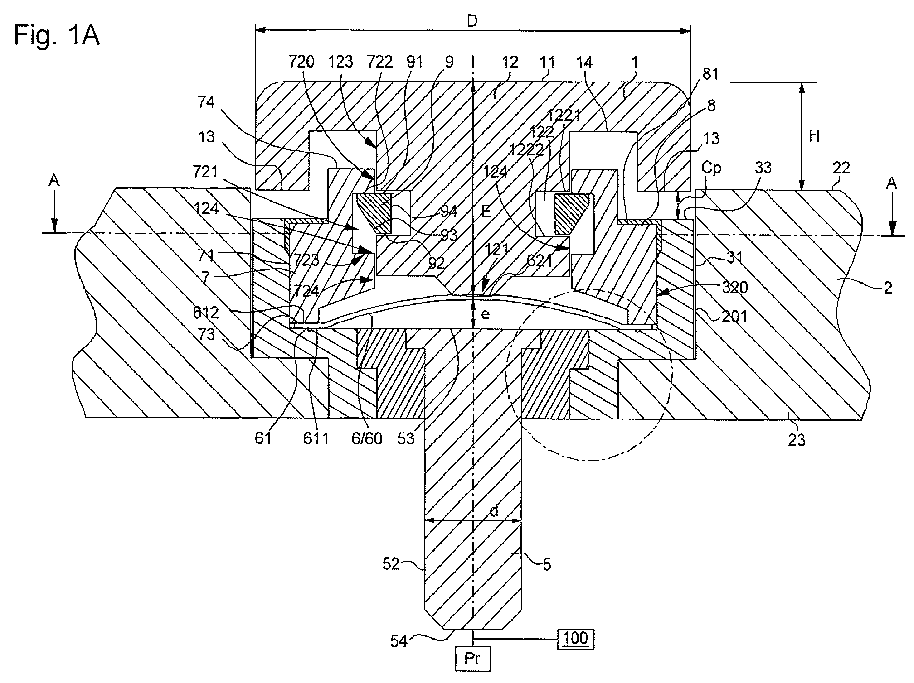

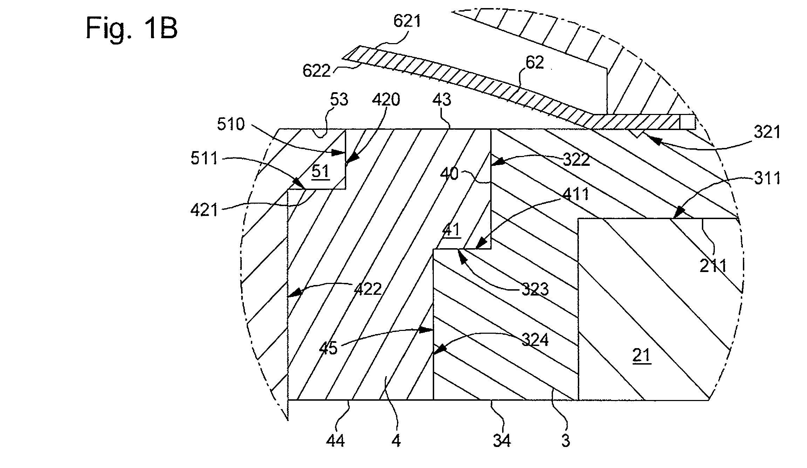

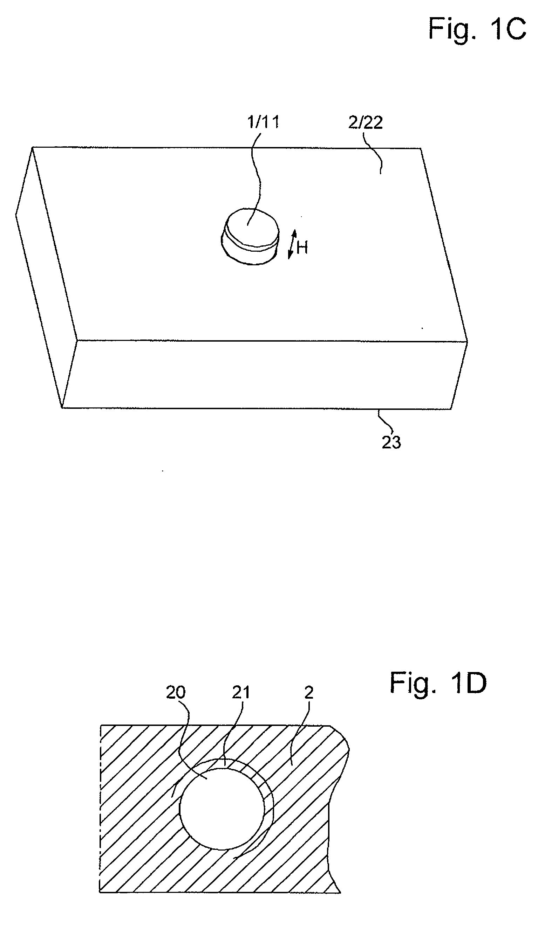

Les figures 1A, 1B et 1C qui suivent montrent deux vues différentes, respectivement en coupe et de dessus, d'un poussoir selon un mode de réalisation préférentiel de l'invention, selon lequel la tête de poussoir 1 ressort légèrement de la carrure 2 de la montre lorsque le poussoir est en position de repos Pr. Selon ce mode de réalisation préférentiel, le poussoir peut être assemblé de façon modulaire en dehors de la carrure 2, avant d'être introduit dans un trou traversant 20 de la carrure 2, illustré à la figure 1 D. La figure 1 B consiste simplement en un agrandissement de la figure 1A au niveau de l'assemblage de différentes pièces. Cette figure 1 B ayant été introduite pour des questions de lisibilité pour y ajouter des références concernant les différentes pièces illustrées, dans ce qui suit on se référera conjointement à ces deux figures pour la lecture des références des pièces décrites dans la description.

Comme on peut le constater sur la vue en coupe de la figure 1 A, la tête de poussoir 1 comprend une surface supérieure 11 sensiblement plane, contre laquelle est censé venir en contact un des doigts de l'utilisateur pour enfoncer le poussoir et activer une fonction prédéterminée, comme par exemple le départ d'un chronomètre, l'enclenchement d'une alarme etc., qui est surélevée par rapport à la surface externe 22 de la carrure 2 d'une hauteur H, de préférence inférieure égale à 2 millimètres, comme illustré sur la figure 1C. Cette hauteur H permet une légère saillie en dehors de la carrure 2 et ainsi une meilleure saisie par l'utilisateur, sans toutefois que cette saillie ne soit gênante pour le confort au porter en raison de l'encombrement additionnel ainsi que des arêtes plus proéminentes qui sont formées et peuvent entrer au contact de la peau.

Selon le mode de réalisation préférentiel illustré, la tête de poussoir 1 comprend une surface inférieure périphérique de butée 13 annulaire, destinée à venir en contact avec une surface externe 33, également annulaire, d'un corps de poussoir 3 dans lequel l'ensemble des pièces du poussoir sont assemblées. La surface inférieure périphérique de butée 13 affleure au niveau de la surface externe 22 de la carrure 2, de telle sorte que la hauteur H est aussi égale à l'épaisseur du poussoir dans sa partie périphérique, soit la différence de hauteur entre la surface supérieure 11 de la tête de poussoir 1 et la surface inférieure périphérique de butée 13, comme illustré sur la figure 1 A.

La surface supérieure 11 de la tête de poussoir est un disque dont le diamètre D est de préférence compris entre 4 et 5 millimètres pour permettre une bonne préhension par l'utilisateur. Ces dimensions sont équivalentes à celles d'un poussoir mécanique traditionnel, mais posent toutefois des contraintes en termes de surfaces pour réaliser des armatures d'un condensateur dans le cadre d'un mode de réalisation capacitif, pour lequel l'ordre de grandeur de la taille des armatures est environ 10 fois plus grand, comme par exemple pour des touches de clavier ou des boutons d'appareils photographiques dont les surfaces de préhension externes sont de l'ordre de 1 centimètre carré. En effet, la valeur de la capacité d'un condensateur plan est directement proportionnelle à la taille des surfaces en regard l'une de l'autre; ces surfaces sont par conséquent très réduites dans le cadre de l'invention, ce qui nécessite de réduire leur espacement mutuel lorsqu'une activation doit être détectée, ou encore adapter la forme géométrique des armatures, comme expliqué ci-après.

La tête de poussoir 1 comprend une partie centrale 12, guidée axialement en translation vers l'intérieur de la carrure 2 par une pièce de guidage 7, dont les premières et deuxièmes surfaces latérales internes 720 et respectivement 724 coopèrent respectivement avec la première surface latérale externe 123 et la deuxième surface latérale externe 124. Une surface inférieure 121 de la partie centrale 12 de la tête de poussoir est en contact avec une surface supérieure 621 de la partie centrale déformable 62 de la capsule, et tout mouvement en translation de la tête du poussoir 1 vers l'intérieur tendra à déformer la capsule 60 pour la rapprocher du premier élément de contact 5 fixe du dispositif interrupteur de l'invention, en contact avec un circuit électronique de détection 100. Selon un mode de réalisation préférentiel, la tête de poussoir 1 est réalisée en matériau isolant, comme par exemple du plastique, et l'épaisseur de la partie centrale E est choisie de préférence supérieure ou égale à 3 millimètres, afin d'isoler électriquement au mieux l'élément conducteur mobile 6 agencé au niveau de la capsule 60 de l'extérieur de la carrure 2, par exemple pour un usage dans l'eau ou éviter tout parasitage capacitif lorsqu'un doigt est simplement apposé sur la surface supérieure 11 de la tête de poussoir 1 lorsque la tête de poussoir est dans sa position de repos Pr.

Selon le mode de réalisation préférentiel illustré aux figures 1 et 1 B, la capsule 60 est fixée hermétiquement au dessus du premier conducteur fixe 5 par sa partie périphérique 61, annulaire, collée ou soudée par sa surface inférieure 611 au corps de poussoir 3, et recouverte au niveau de la surface supérieure 612 de cette même partie périphérique 61 par une surface inférieure 73 de la pièce de guidage 7, chassée dans le corps de poussoir 3. Le fait de chasser la pièce de guidage 7 au niveau de la partie périphérique 61 de la capsule 60 permet d'améliorer l'étanchéité du poussoir en empêchant toute infiltration d'eau par l'extérieur de la capsule 60. Selon une variante, la capsule ne comporte plus de collerette, c'est-à-dire de partie périphérique annulaire 612, et l'étanchéité est assurée par un joint de colle silicone disposé sur sa surface supérieure 612. La capsule est de préférence métallique, et par conséquent intégralement conductrice, de telle sorte qu'elle forme à elle seule le deuxième élément conducteur 6 sans nécessiter l'ajout d'une pièce conductrice par collage ou soudage sur la surface inférieure 622 ou supérieure 621 de sa partie centrale 62 plastiquement déformable. Afin d'empêcher toute corrosion de la capsule 60 dont la partie centrale 62 de laquelle sera amenée à être régulièrement en contact avec l'eau, on pourra choisir un matériau inoxydable comme l'aluminium, ou tout type d'alliage inoxydable, ou encore recouvrir la capsule 60 d'une feuille plastique laminée.

Lorsque la capsule 60 est métallique, on choisira de préférence un matériau également métallique pour le corps de poussoir 3 afin d'améliorer la sensibilité du condensateur dont l'armature externe est formée par la capsule 60 conductrice et le corps de poussoir 3, et l'armature interne est formée par le premier élément conducteur 5, fixe et ici agencé comme une pièce traversante par rapport à la carrure 2. Cet agencement confère une structure mixte entre un condensateur plan et un condensateur cylindrique grâce au diélectrique formé par la pièce isolante 4 annulaire interposé entre le premier élément conducteur 5 et le corps de poussoir 3, qui augmente significativement la capacité du condensateur formé par rapport à un condensateur qui ne comprendrait qu'une première armature formée par la partie centrale 62 de la capsule 60 et la surface supérieure 53 de la pièce conductrice. En effet, cette surface supérieure 53 n'est égale au maximum, selon le mode de réalisation préférentiel décrit, qu'à environ 1 millimètre carré pour pouvoir loger le corps de poussoir 3 et la pièce isolante 4. Selon le mode de réalisation préférentiel illustré aux figures 1 A et 1 B, le diamètre d du premier élément conducteur fixe 5 entre ses surfaces latérales 52 est égal à environ 1 millimètre, et l'épaulement 51 prévu pour son montage permet d'en agrandir légèrement la surface supérieure 53 en regard avec le 2^{e} élément conducteur.

Comme indiqué précédemment, la variante préférentielle décrite du poussoir peut être montée modulairement dans le corps de poussoir 3 en dehors de la carrure 2, puis emmanchée à force dans le trou traversant 20 illustré à la figure 1 D, qui correspond à une vue en coupe selon l'axe A-A des figures 1A et 1B. Ce trou traversant 20 comprend un épaulement 21, visible également sur la figure 1 A, sur lequel une surface de butée 211 est aménagée et contre laquelle la surface de butée 311 du corps de poussoir est amené en contact, tandis que la surface latérale externe du poussoir 31 est de préférence retenue par friction dans le trou traversant le long de ses parois latérales 201. On peut également envisager fixer le corps de poussoir par collage ou soudage sur l'une ou l'autre des parois suscitées (référencées 201, 211 sur la figure 1 A), ou encore disposer un joint le long de la paroi latérale 201 du trou traversant 20 afin d'améliorer l'étanchéité de l'assemblage.

Afin de faciliter les opérations de montage, non seulement l'orifice pratiqué dans la carrure 2 mais également le premier élément de contact 5 et la pièce isolante 4 peuvent comprendre des épaulements pour s'emboîter les uns dans les autres, comme illustré sur la figure 1B. L'épaulement 51 du premier élément conducteur 5 comprend une première surface de butée inférieure 511 amenée en contact sur une deuxième surface de butée 421 de la pièce isolante 4, alors que la surface latérale externe de l'épaulement 510 est amené en contact sur la première surface latérale interne 420 d'assemblage et que la surface latérale du premier élément conducteur 52 est en contact avec la deuxième surface latérale interne d'assemblage 422 de la pièce isolante. Similairement la pièce isolante 4 comprend un épaulement 41 comprenant une surface latérale externe 410 est amenée en contact d'une deuxième surface d'assemblage interne du corps de poussoir 322 - la première surface d'assemblage interne du corps de poussoir 320 étant prévue pour le montage de la pièce de guidage 7 - et une première surface de butée inférieure 411 amenée en contact sur une troisième surface de butée 323 du corps de poussoir 3 - les premières et deuxièmes surfaces de butées 311 et 321 étant respectivement prévues pour le montage sur l'épaulement 21 du trou traversant 20 et le montage de la partie périphérique 61 de la capsule 60. La surface latérale de l'élément isolant 45 est en contact avec la troisième surface latérale interne d'assemblage 324 du corps de poussoir 3. Grâce à ces différents épaulements visibles sur la figure 1A et plus en détail sur la figure 1 B, le positionnement axial relatif des différentes pièces (c'est-à-dire le premier élément conducteur 5, la pièce isolante 4 et le corps de poussoir 3 par rapport à l'intérieur de la carrure 2) est aisé, de même que le montage par emmanchement à force le long des différentes surfaces d'assemblage. Bien que les surfaces d'assemblage entre ces différentes pièces soient verticales, on pourrait imaginer des surfaces légèrement obliques pour faciliter l'opération de montage par friction. Comme on peut le constater sur les figures 1 A et 1 B, la surface supérieure du premier élément conducteur 53, la surface supérieure de l'élément isolant 43 et la deuxième surface de butée du corps de poussoir 321 affleurent au même niveau horizontal. Cet alignement horizontal permet de gérer efficacement l'espacement e entre le premier élément conducteur 5 fixe et le deuxième élément conducteur mobile 6, qui détermine la capacité nominale du condensateur formé entre ces deux conducteurs simplement en fonction du bombage de la capsule 60, c'est-à-dire l'écart vertical entre le sommet de la capsule, en contact avec la première surface inférieure 121 de la partie centrale 12 de la tête de poussoir 1, et la partie périphérique 61. Similairement la surface inférieure du corps de poussoir 34 affleure au même niveau horizontal que la surface inférieure de la pièce isolante 44, et que la surface inférieure de la carrure 23 tandis que la surface inférieure du premier élément conducteur 54 est située plus vers l'intérieur de la carrure 2 pour être connectée ensuite vers le circuit de détection 100 en nécessitant le moins de câblage possible. On pourrait toutefois imaginer que la surface inférieure du premier élément conducteur 54 affleure au même niveau horizontal que la surface inférieure de la pièce isolante 44 et des autres surfaces inférieures suscitées.

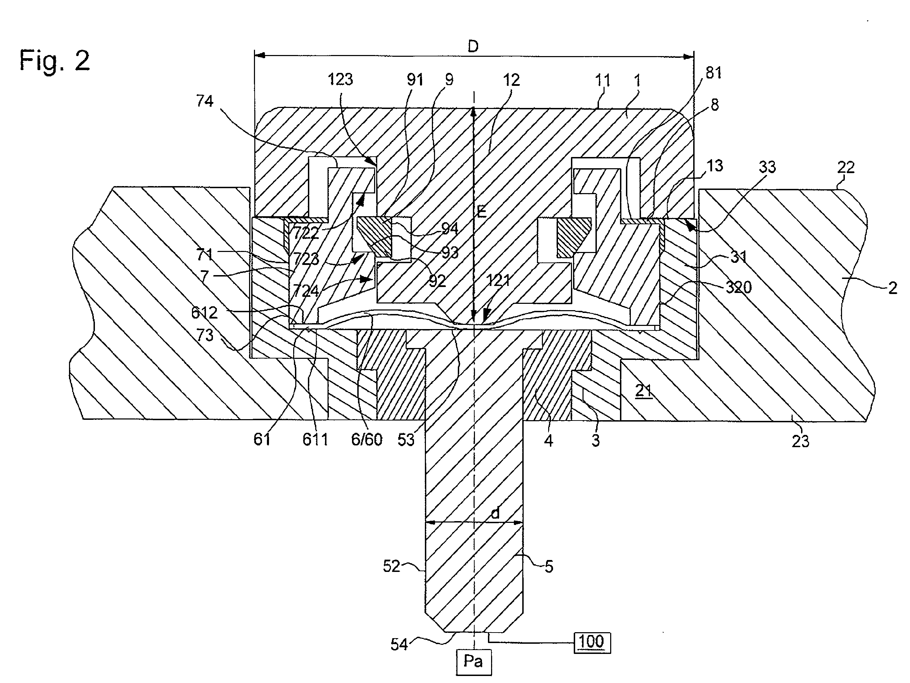

Selon le mode de réalisation préférentiel illustré, on peut donc emboîter le premier élément conducteur 5, cylindrique avec un épaulement 51 au niveau de sa surface supérieure 53, dans la pièce isolante 4, qui présente une forme annulaire et également un épaulement 41 au niveau de sa surface supérieure 43 pour un emboîtement dans le corps de poussoir 3. Une fois ces trois pièces assemblées, on peut procéder au montage de la capsule 60 dans le corps de poussoir 3, par la surface inférieure 611 de la partie périphérique 61 sur la deuxième surface de butée 321 du corps de poussoir 3. On peut ensuite monter la pièce de guidage 7 le long de la première surface d'assemblage interne 320 du corps de poussoir 3 sur la surface supérieure 612 de la partie périphérique 61 de la capsule 60. La surface d'assemblage interne 320 du corps de poussoir coopère avec la surface d'assemblage externe 71 de la pièce de maintien 71. Pour améliorer la fixation de la pièce de guidage 7 dans le corps de poussoir 3, on pourra utiliser un anneau de fixation 8 avec une section en forme d'équerre et qui recouvre partiellement la pièce de guidage 7. L'anneau de fixation 8 selon le mode de réalisation préférentiel illustré à la figure 1A présente par ailleurs l'avantage d'avoir une surface supérieure 81 affleurant à la surface externe 33 du corps de poussoir 3, de telle sorte qu'elle forme une surface de butée prolongée faisant face à la surface inférieure périphérique de butée 13 de la tête de poussoir 1 et conditionne la course Cp du poussoir, correspondant à l'écart vertical entre la surface supérieure de la tête de poussoir 1 dans la position de repos Pr et la position active Pa, illustrée par la figure 2 décrite ci-après. Selon le mode de réalisation décrit, cette course du poussoir Cp correspond également à l'écart entre les deux surfaces référencées 13 et 33.

Une fois que la pièce de guidage 7 est fixée, il reste encore à assembler la tête de poussoir 1 à l'intérieur de cette pièce. Comme on peut le constater sur la figure 1A, la partie centrale 12 de la tête de poussoir 1 comprend des premières et deuxièmes surfaces latérales 123 et respectivement 124, alignées et verticales, entre lesquelles sont aménagées un évidement 122 pour loger une bride de maintien 9. Similairement la pièce de guidage 7 comprend une première surface latérale interne 720 et une deuxième surface latérale interne 724, alignées et verticales, entre lesquelles est aménagé un évidement 721. En position assemblée, la bride de maintien 9 déborde légèrement latéralement de l'évidement 122 refermé par ses surfaces de butée supérieure 1221 et inférieure 1222, entre lesquelles elle est positionnée axialement par rapport à la tête de poussoir 1 par l'intermédiaire de ses surfaces supérieure 91 et inférieure 92; elle est partiellement logée dans un évidement 721 pratiqué dans la pièce de guidage 7. Afin d'empêcher tout mouvement de la bride de maintien 9 vers l'extérieure de la carrure 2 et par conséquent la sortie de la tête de poussoir 1 dont elle est solidaire axialement, la partie saillante de la surface supérieure 91 de la bride de maintien située hors de l'évidement de la partie centrale 122 est retenue en butée contre la surface de retenue 722 de la pièce de guidage 7, refermant l'évidement 721 de cette pièce vers le haut. La course de la tête de poussoir 1 n'est toutefois pas limitée par la surface de butée inférieure 723 vers l'intérieur de la carrure 2 grâce à la surface latérale oblique 93 de la bride de maintien 9 qui peut glisser - sur l'arête de l'évidement 721 (c'est-à-dire formé par les surfaces référencées 723 et 724), alors que cette dernière est compressée radialement. Cet agencement d'une surface latérale externe 93 oblique et orientée vers le centre pour la bride de maintien 9 permet également de l'insérer plus facilement dans l'évidement de la pièce de guidage 721, car elle est guidée progressivement radialement vers l'intérieur lorsque la tête de poussoir 1 est dirigé vers l'intérieur du corps de poussoir 3 et qu'elle entre en contact avec l'arête formée par la surface supérieure de la pièce de guidage 74 et la première surface latérale interne 720 de cette même pièce de guidage 7. Pour pouvoir effectuer un tel montage de la tête de poussoir, on pourra remarquer que la largeur de la surface supérieure de la bride de maintien 91 devra nécessairement être inférieure ou égale à la profondeur de l'évidement 122 pratiqué dans la partie centrale 12 de la tête de poussoir 1, de telle sorte que la surface latérale interne de la bride de maintien 94 ne soit pas en butée avec le fond de l'évidement 122 avant que suffisamment d'espace n'ait été libéré pour permettre le passage de la première surface latérale externe de la partie centrale du poussoir 123 le long de la première surface latérale interne de la pièce de guidage 720.

On pourra également remarquer que, selon le mode de réalisation préférentiel illustré, l'épaisseur E du poussoir ainsi que le positionnement axial de la surface de retenue 722 de la pièce de guidage 7 sont configurés de telle sorte que, dans la position de repos Pr de la tête de poussoir 1, la surface inférieure 121 de la tête de poussoir 1 est en contact avec la surface supérieure 621 de la capsule 60 sans que cette dernière ne soit déformée, alors que la surface supérieure 91 de la bride de maintien 9 est en contact avec la surface de retenue 722 de la pièce de guidage 7. La tête de poussoir 1 est ainsi maintenue dans cette position de repos Pr sans aucun jeu axial car la capsule 60 exerce une force de rappel vers l'extérieur de la carrure 2 qui tend à comprimer la partie saillante de surface supérieure 91 de la bride vers la surface de retenue 722.

Dans le mode de réalisation préférentiel illustré sur la figure 1A, l'espacement e entre la surface de contact fixe 5 et la surface de contact mobile 6, soit la surface interne de la partie centrale de la capsule 622 au centre du bombage est d'au moins 0.3 millimètre dans la position de repos Pr du poussoir afin d'isoler électriquement au mieux l'élément conducteur mobile lors d'une immersion du poussoir, au cours de laquelle de l'eau peut s'introduire à l'intérieur de la pièce de maintien jusqu'à la surface supérieure 621 de la partie centrale déformable de la capsule 60 et créer un parasitage capacitif. L'augmentation de la distance minimale dans la position de repos du poussoir Pr entre la surface externe 53 du premier élément conducteur fixe 5 et tout autre élément conducteur, situé nécessairement au-delà de la capsule 60, permet de réduire fortement ces capacités parasites. Afin d'éviter toute activation intempestive, on pourra par ailleurs utiliser un circuit électronique de détection 100 par variation relative, comme par exemple celui décrit dans le brevet EP0838737 de la demanderesse, ayant un seuil de détection fixé à plus de 5%, sachant que les capacités parasites correspondant à une détection tactile ne dépassent en général pas 3%. Empiriquement il a été constaté que l'introduction d'eau dans le poussoir selon l'invention ne générait pas de variation de capacité de plus de 2%, de telle sorte que le seuil suscité de 5% d'écart relatif suffit à écarter ces deux types de capacités parasites.

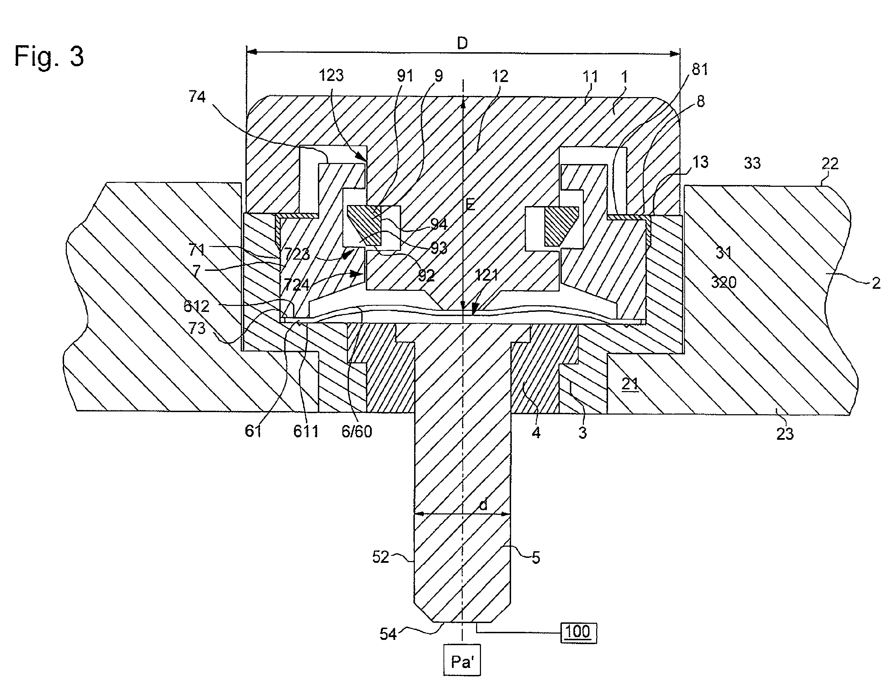

Selon le mode de réalisation préférentiel décrit aux figures 1A, 1B2, et 3, la course du poussoir Cp entre la position de repos Pr et la première position active Pa (figure 2) et la deuxième position active Pa' (figure 3) de la tête du poussoir 1 est inférieure ou égale à 0.3 millimètre, soit moins de deux fois moins que pour des poussoirs mécaniques classiques, pour lesquelles la course du poussoir est comprise en général entre 0.5 et 1 millimètre. Il serait impossible de réduire la course des poussoirs mécaniques classiques sans que cela soit néfaste à la fiabilité des activations, car pour de tels poussoirs il est nécessaire de récupérer toutes les erreurs de tolérances de positionnement des pièces à l'intérieur du boîtier, et notamment celles responsables des enclenchements mécaniques. L'accumulation des erreurs de tolérance rendrait impossible une diminution de la course à des valeurs inférieures à 0.5 millimètres.

La seule différence entre les figures 1 A, 2 et 3 étant le positionnement vertical de la tête du poussoir 1, seuls les éléments changeant entre la figure 1A et les figures 2 et 3 seront décrits en détail dans ce qui suit, les autres références étant en tous points identiques à celles des figures 1 A et 1 B.

Selon le mode de réalisation illustré à la figure 2, montrant le poussoir de la figure 1A non plus en position de repos Pr mais dans une première position active Pa, on peut constater que l'espacement e entre la surface extérieure 53 du premier élément de contact fixe 5 et la surface inférieure de la partie centrale de la capsule 621, ici métallique et par conséquent conductrice, est exactement égale à la course Cp du poussoir. Toutefois, selon le mode de réalisation alternatif illustré à la figure 3, montrant le poussoir dans une deuxième position active Pa' selon laquelle la surface inférieure de la partie centrale de la capsule 621 n'est plus en contact avec la surface extérieure 53 du premier élément de contact fixe 5 cet espacement e est choisi légèrement supérieur à la course du poussoir Cp, déterminé ici par l'écart vertical entre la surface inférieure périphérique de la tête de poussoir 13 et la surface supérieure du corps de poussoir 33. On a donc dans tous les cas une course du poussoir qui est limitée par l'espacement e, c'est-à-dire la relation *Cp* ≤ *e,* la figure 2 illustrant le cas particulier *Cp =* e pour lequel il est possible de choisir entre un mode de détection capacitif ou résistif, puisque les deux éléments conducteurs fixes 5 et mobiles 6 sont en contact physique. Pour les cas où la course du poussoir Cp est strictement inférieure à l'espacement e, comme pour le mode de réalisation illustré à la figure 3, seul le mode de détection capacitive sera possible.

Selon le mode de réalisation préférentiel illustré, la pièce de guidage 7 effectue un guidage axial rectiligne pour la partie centrale de la tête de poussoir 12 vers l'intérieur de la carrure 2; on pourrait toutefois imaginer que la course de la tête de poussoir est curviligne, par exemple pour une tête de poussoir 1 dont la surface supérieure 12 est inclinée par rapport à la surface supérieure de la carrure 22 et pivote autour d'un axe pour exercer une force de déformation sur la capsule 60. Bien que la course du poussoir Cp soit déterminée de préférence par la collaboration entre surface inférieure périphérique de la tête de poussoir 13 et la surface supérieure du corps de poussoir 33, on pourrait imaginer que cette course puisse être déterminée par d'autres surfaces, comme une deuxième surface inférieure de la tête de poussoir 14 arrivant en butée sur la surface supérieure de la pièce de guidage 74.

Sur les figures 2 et 3, on peut constater que la courbure de la capsule 60 est inversée; l'inversion de cette courbure a lieu lorsqu'une force dépasse un seuil d'activation mécanique. Selon un mode de réalisation préférentiel, le bombage de la capsule 60, qui correspond à l'écart vertical entre son sommet et les parties périphériques, et par conséquent l'espacement *e* entre les éléments de contact, son diamètre, son épaisseur ainsi que la rigidité du matériau utilisé sont configurés pour déterminer un seuil d'activation inférieur ou égal à 500 grammes, et de préférence entre 400 et 500 grammes. Ce seuil d'activation est largement inférieur à ceux utilisés dans le cadre de poussoirs mécaniques, pour lesquels la présence de joints épais pour garantir l'étanchéité par rapport à l'intérieur du boîtier impose des forces d'activation supérieures à 500 grammes. Afin de faciliter la déformation de la capsule et réduire encore le seuil d'activation ci-dessus, on pourra choisir la surface inférieure de contact de la tête de poussoir 121 la plus petite possible, comme dans le mode de réalisation préférentiel illustré où elle est agencée à l'extrémité d'une petite partie protubérante sous la partie centrale de la tête de poussoir 12, ce qui permet de maximiser la pression exercée sur le sommet de la capsule 60.

La solution proposée présente l'avantage, par rapport à une solution électronique, de fournir également un clic de confirmation mécanique d'activation lorsque la tête de poussoir 1 est dans en position active, avec une capsule 60 soit partiellement déformée comme dans la figure 3, soit complètement déformée avec sa surface inférieure de la partie centrale 622 en appui contre la surface supérieure 53 du premier élément conducteur 5, comme sur la figure 2. Le feedback mécanique d'un déclenchement effectif est toutefois procuré dans le cadre de l'invention non seulement pour une détection de type résistif, comme par exemple pour l'enfoncement de touches de claviers, mais également pour une détection de type purement capacitif.

Ainsi le poussoir selon le mode de réalisation préférentiel décrit permet d'améliorer significativement les propriétés d'étanchéité d'une solution totalement mécanique, tout en conférant à l'utilisateur un confort d'usage similaire grâce à l'effet clic émulant une activation mécanique usuelle.

Bien que le mode de réalisation préférentiel décrit utilise un corps de poussoir 3, on comprendra toutefois qu'il est également envisageable, selon un mode de réalisation alternatif non illustré, de loger le poussoir directement dans la carrure 2, ce qui permet de réaliser l'économie d'une pièce mais empêche tout montage modulaire en dehors de la carrure et nécessite un usinage de surfaces de montage adéquates directement dans la carrure 2.

## Revendications

1. Montre bracelet comprenant :
- une carrure (2) comportant un trou traversant (20)
- un poussoir étanche comprenant :
∘ un corps de poussoir (3) positionné contre des parois du trou traversant (20)
∘ une tête de poussoir (1) dont une partie est positionnée dans une portion supérieure du trou traversant (20), la tête de poussoir (1) étant mobile entre une position de repos (Pr) et une position active (Pa, Pa')
∘ un premier élément conducteur (5) fixe dont une partie est positionnée dans une portion inférieure du trou traversant (20), et
∘ un deuxième élément conducteur (6) mobile,
le poussoir comprenant une capsule (60) comprenant le deuxième élément conducteur (6) mobile, la capsule (60) étant positionnée dans le trou traversant (20) entre la tête de poussoir (1) et le premier élément conducteur (5) fixe et étant fixée périphériquement au corps de poussoir (3), la capsule (60) recouvrant hermétiquement ledit premier conducteur fixe (5), une surface supérieure (621) de ladite capsule (60) étant en contact physique avec une surface inférieure (121) de la tête de poussoir (1), ladite capsule (60) étant élastiquement déformable et se trouvant :
- dans une position non déformée lorsque la tête de poussoir (1) est dans sa position de repos (Pr) et
- dans une position déformée lorsque la tête de poussoir (1) est dans sa position active (Pa, Pa'),
lesdits premier et deuxième éléments conducteurs (5, 6) formant un dispositif interrupteur de type capacitif ou résistif, ledit interrupteur étant à l'état ouvert lorsque la tête de poussoir (1) est dans sa position de repos (Pr) et à l'état fermé lorsque la tête de poussoir (1) est dans sa position active (Pa, Pa').

2. Montre bracelet selon la revendication 1, **caractérisée en ce que** la tête de poussoir (1) est guidée axialement et que la course de la tête de poussoir (Cp) entre ladite position de repos (Pr) et la position active (Pa, Pa') est inférieure ou égale à 0.3 millimètre.

3. Montre bracelet selon la revendication 2, **caractérisée en ce que** la tête de poussoir (1) comprend une surface de butée périphérique inférieure (13) déterminant ladite course de la tête de poussoir (Cp).

4. Montre bracelet selon l'une des revendications précédentes, la surface externe (53) dudit premier élément conducteur (5) étant d'au maximum 1 millimètre carré et l'espacement (e) entre ladite surface externe (53) dudit premier élément conducteur (5) et une surface de l'élément de contact mobile (6) étant d'au moins 0.3 millimètre dans ladite position de repos (Pr) du poussoir.

5. Montre bracelet selon l'une des revendications 2 à 4, **caractérisée en ce que** l'espacement (e) entre ladite surface de contact fixe (5) et ladite surface de l'élément de contact mobile (6) est supérieure ou égale à ladite course (Cp) du poussoir.

6. Montre bracelet selon l'une des revendications précédentes, ladite capsule (60) étant agencée pour déterminer un seuil d'activation inférieur à 500 grammes et étant telle que :
- dans la position non déformée, la surface supérieure (621) est courbée dans le sens de la tête de poussoir (1)
- dans la position déformée, la surface supérieure (621) est courbée dans le sens du premier élément conducteur fixe (5)
- l'inversion de la courbure de la surface supérieure de la capsule entre sa position non déformée et sa position déformée procure un clic de confirmation mécanique d'activation lorsque la tête de poussoir (1) passe de la position de repos (Pr) à la position active (Pa, Pa').

7. Montre bracelet selon l'une des revendications précédentes, une partie centrale déformable (62) de ladite capsule (60) formant l'élément conducteur mobile (6).

8. Montre bracelet selon l'une des revendications précédentes, **caractérisée en ce qu'**une partie périphérique de ladite capsule (61) est fixée au corps de poussoir (3) annulaire rapporté sur la carrure (2) de la montre.

9. Montre bracelet selon la revendication 8, ladite capsule (60) et ledit corps de poussoir (3) étant conducteurs.

10. Montre bracelet selon la revendication 9, **caractérisée en ce que** le premier conducteur (5) est traversant et que le poussoir comprend une pièce isolante (4) annulaire interposée entre ledit premier conducteur (5) et ledit corps de poussoir (3).

11. Montre bracelet selon l'une des revendications précédentes, **caractérisée en ce que** le poussoir comprend une pièce de guidage (7) de ladite tête de poussoir (1), ladite pièce de guidage (7) étant chassée sur une partie périphérique (61) de ladite capsule (60).

12. Montre bracelet selon l'une des revendications précédentes, **caractérisé en ce que** le poussoir comprend une bride de maintien (9) de ladite tête de poussoir (1) logée partiellement dans un évidement (122) de la partie centrale (121) de la tête de poussoir (1).

13. Montre bracelet selon la revendication 12, ladite bride de maintien (9) comprenant une surface latérale externe (93) oblique.

14. Montre bracelet selon l'une des revendications précédentes, ledit premier élément conducteur (5) fixe étant connecté à un circuit électronique de détection (100) par variation relative d'impédance.

15. Montre bracelet selon la revendication 14, le seuil de détection étant fixé à plus de 5%.

## Patentansprüche

1. Armbanduhr, die umfasst:
- ein Gehäusemittelteil (2), das ein Durchgangsloch (20) aufweist,
- einen abgedichteten Drücker, der enthält:
∘ einen Drückerkörper (3), der anliegend an den Wänden des Durchgangslochs (20) positioniert ist;
∘ einen Drückerkopf (1), wovon ein Teil in einem oberen Abschnitt des Durchgangslochs (20) positioniert ist, wobei der Drückerkopf (1) zwischen einer Ruhestellung (Pr) und einer aktiven Stellung (Pa, Pa') beweglich ist,
∘ ein erstes, festes Leiterelement (5), wovon ein Teil in einem unteren Abschnitt des Durchgangslochs (20) positioniert ist, und
∘ ein zweites, bewegliches Leiterelement (6),
wobei der Drücker eine Kapsel (60) umfasst, die das zweite bewegliche Leiterelement (6) enthält, wobei die Kapsel (60) in dem Durchgangsloch (20) zwischen dem Drückerkopf (1) und dem ersten, festen Leiterelement (5) positioniert ist und in Umfangsrichtung am Drückerkörper (3) befestigt ist, wobei die Kapsel (60) den ersten festen Leiter (5) hermetisch abdeckt, wobei eine obere Oberfläche (621) der Kapsel (60) mit einer unteren Oberfläche (121) des Drückerkopfes (1) in körperlichem Kontakt ist, wobei die Kapsel (60) elastisch verformbar ist und:
- sich in einer nicht verformten Position befindet, wenn der Drückerkopf (1) in seiner Ruhestellung (Pr) ist, und
- sich in einer verformten Position befindet, wenn der Drückerkopf (1) in seiner aktiven Position (Pa, Pa') ist,
wobei das erste und das zweite Leiterelement (5, 6) eine Ein/Aus-Vorrichtung des kapazitiven oder ohmschen Typs bilden, wobei die Ein/Aus-Vorrichtung im geöffneten Zustand ist, wenn der Drückerkopf (1) in seiner Ruhestellung (Pr) ist, und im geschlossenen Zustand ist, wenn der Drückerkopf (1) in seiner aktiven Position (Pa, Pa') ist.

2. Armbanduhr nach Anspruch 1, **dadurch gekennzeichnet, dass** der Drückerkopf (1) axial geführt wird und dass die Bahn des Drückerkopfes (Cp) zwischen der Ruhestellung (Pr) und der aktiven Stellung (Pa, Pa') kleiner oder gleich 0,3 Millimeter ist.

3. Armbanduhr nach Anspruch 2, **dadurch gekennzeichnet, dass** der Drückerkopf (1) eine untere Umfangsanschlagoberfläche (13) aufweist, der die Bahn des Drückerkopfes (Cp) bestimmt.

4. Armbanduhr nach einem der vorhergehenden Ansprüche, wobei die äußere Oberfläche (53) des ersten Leiterelements (5) höchstens 1 Quadratmillimeter beträgt und der Abstand (e) zwischen der äußeren Oberfläche (53) des ersten Leiterelements (5) und einer Oberfläche des beweglichen Kontaktelements (6) in der Ruhestellung (Pr) des Drückers wenigstens 0,3 Millimeter beträgt.

5. Armbanduhr nach einem der Ansprüche 2 bis 4, **dadurch gekennzeichnet, dass** der Abstand (e) zwischen der festen Kontaktoberfläche (5) und der Oberfläche des beweglichen Kontaktelements (6) größer oder gleich der Bahn (Cp) des Drückers ist.

6. Armbanduhr nach einem der vorhergehenden Ansprüche, wobei die Kapsel (60) dafür ausgelegt ist, einen Aktivierungsschwellenwert festzulegen, der kleiner als 500 Gramm ist, und derart beschaffen ist, dass:
- in der nicht verformten Position die obere Oberfläche (621) in Richtung des Drückerkopfs (1) gekrümmt ist,
- in der verformten Position die obere Oberfläche (621) in Richtung des ersten, festen Leiterelements (5) gekrümmt ist,
- die Umkehrung der Krümmung der oberen Oberfläche der Kapsel zwischen ihrer nicht verformten Position und ihrer verformten Position einen Klick zur Bestätigung der mechanischen Aktivierung hervorruft, wenn der Drückerkopf (1) von der Ruhestellung (Pr) in die aktive Stellung (Pa, Pa') übergeht.

7. Armbanduhr nach einem der vorhergehenden Ansprüche, wobei ein verformbarer Mittelteil (62) der Kapsel (60) das bewegliche Leiterelement (6) bildet.

8. Armbanduhr nach einem der vorhergehenden Ansprüche, **dadurch gekennzeichnet, dass** ein Umfangsteil der Kapsel (61) an dem ringförmigen Drückerkörper (3), der an das Gehäusemittelteil (2) der Uhr angefügt ist, befestigt ist.

9. Armbanduhr nach Anspruch 8, wobei die Kapsel (60) und der Drückerkörper (3) Leiter sind.

10. Armbanduhr nach Anspruch 9, **dadurch gekennzeichnet, dass** der erste Leiter (5) ein Durchgangsleiter ist und dass der Drücker ein ringförmiges Isolierteil (4) aufweist, das zwischen dem ersten Leiter (5) und dem Drückerkörper (3) eingefügt ist.

11. Armbanduhr nach einem der vorhergehenden Ansprüche, **dadurch gekennzeichnet, dass** der Drücker ein Teil (7) zum Führen des Drückerkopfes (1) umfasst, wobei das Führungsteil (7) auf ein Umfangsteil (61) der Kapsel (60) getrieben ist.

12. Armbanduhr nach einem der vorhergehenden Ansprüche, **dadurch gekennzeichnet, dass** der Drücker einen Steg (9) zum Halten des Drückerkopfs (1) umfasst, der teilweise in einer Aussparung (122) des Mittelteils (121) des Drückerkopfes (1) aufgenommen ist.

13. Armbanduhr nach Anspruch 12, wobei der Haltesteg (9) eine schräge äußere Seitenoberfläche (93) aufweist.

14. Armbanduhr nach einem der vorhergehenden Ansprüche, wobei das erste, feste Leiterelement (5) mit einer elektronischen Schaltung (100) zur Detektion mittels Veränderung der relativen Impedanz verbunden ist.

15. Armbanduhr nach Anspruch 14, wobei der Detektionsschwellenwert auf mehr als 5 % festgelegt ist.

## Claims

1. Wristwatch comprising:
- a centrepart (2) comprising a through hole (20)
- a sealed pushbutton comprising:
∘ a pushbutton body (3) located against some walls of the through hole (20)
∘ a pushbutton head (1) having a part located in an upper portion of the through hole (20), the pushbutton head (1) being movable between a resting position (Pr) and an active position (Pa, Pa')
∘ a first fixed conductive element (5) having a part located in a lower portion of the through hole (20), and
∘ a second movable conductive element (6),
the sealed button comprising a capsule (60) comprising the second movable conductive element (6), the capsule (60) being located in the through hole (20) between the pushbutton head (1) and the first fixed conductive element (5) and being peripherally fixed to the pushbutton body (3), the capsule (60) hermetically covering said first fixed conductor (5), an upper surface (621) of said capsule (60) being in physical contact with a lower surface (121) of the pushbutton head (1), the capsule (60) being elastically deformable and being:
- in a non-deformed position when the pushbutton head (1) is in its resting position (Pr) and
- in a deformed position when the pushbutton head (1) is in its active position (Pa, Pa'),
said first and second conductive elements (5, 6) forming a capacitive or resistive switch device, said switch being in open state when the pushbutton head (1) is in its resting position (Pr) and in closed state when the pushbutton head (1) is in its active position (Pa, Pa').

2. Wristwatch according to claim 1, **characterised in that** the pushbutton head (1) is axially guided and that the travel of the pushbutton head (Cp) between said resting position (Pr) and the active position (Pa, Pa') is less than or equal to 0.3 millimetre.

3. Wristwatch according to claim 2, **characterised in that** the pushbutton head (1) comprises a lower peripheral abutment surface (13) that determines said travel of the pushbutton head (Cp).

4. Wristwatch according to one of the preceding claims, wherein the outer surface (53) of said first conductive element (5) is 1 square millimetre at maximum and the spacing (e) between said outer surface (53) of said first conductive element (5) and a surface of the movable contact element (6) is at least 0.3 millimetre in said resting position (Pr) of the pushbutton.

5. Wristwatch according to one of claims 2 to 4, **characterised in that** the spacing (e) between said fixed contact surface (5) and said surface of the movable contact element (6) is greater than or equal to said travel (Cp) of the pushbutton.

6. Wristwatch according to one of the preceding claims, wherein said capsule (60) is arranged to determine an activation threshold of less than 500 grams and being such as:
- in the non-deformed position, the upper surface (621) is curved in the direction of the pushbutton head (1)
- in the deformed position, the upper surface (621) is curved in the direction of the first fixed conductive element (5)
- the curvature inversion of the upper surface (621) of the capsule (60) between its non-deformed position and its deformed position provides a mechanical activation confirmation click when the pushbutton head (1) moves from the resting position (Pr) to the active position (Pa, Pa').

7. Wristwatch according to one of the preceding claims, wherein a deformable central part (62) of said capsule (60) forms the movable conductive element (6).

8. Wristwatch according to one of the preceding claims, **characterised in that** a peripheral part of said capsule (61) is fixed to the annular pushbutton body (3) added on the centrepart (2) of the watch.

9. Wristwatch according to claim 8, wherein said capsule (60) and said pushbutton body (3) are conductive.

10. Wristwatch according to claim 9, **characterised in that** the first conductor (5) is transversal and that the sealed pushbutton comprises an annular insulating piece (4) interposed between said first conductor (5) and said pushbutton body (3).

11. Wristwatch according to one of the preceding claims, **characterised in that** the sealed pushbutton comprises a guide piece (7) of said pushbutton head (1), wherein said guide piece (7) is pressed onto a peripheral part (61) of said capsule (60).

12. Wristwatch according to one of the preceding claims, **characterised in that** the sealed pushbutton comprises a holding flange (9) of said pushbutton head (1) partially accommodated in a recess (122) of the central part (121) of the pushbutton head (1).

13. Wristwatch according to claim 12, wherein said holding flange (9) has an oblique outer side face (93).

14. Wristwatch according to one of the preceding claims, wherein said first fixed conductive element (5) is connected to an electronic detection circuit (100) based on relative impedance variation.

15. Wristwatch according to claim 14, wherein the detection threshold is fixed at more than 5%.
